# EUROPEAN PATENT SPECIFICATION

(11) **EP 4 500 126 B1**
(45) Date of publication and mention of the grant of the patent: **21.01.2026**
(21) Application number: 23718590.5
(22) Date of filing: 24.03.2023
(51) Int. Cl.: G01J 3/46, G01J 3/50

(54) **TECHNIQUES FOR COLOR MATCHING**
VERFAHREN ZUR FARBABSTIMMUNG
TECHNIQUES DE MISE EN CORRESPONDANCE DE COULEURS

(30) Priority: 29.03.2022 US 202263362056 P; 19.12.2022 US 202263476008 P
(43) Date of publication of application: 05.02.2025
(73) Proprietor: PPG Industries Ohio Inc., Cleveland, OH 44111 (US)
(72) Inventor: GALLAGHER, Kevin Patrick, Gibsonia, Pennsylvania 15044 (US); MAHAFFEY, Caitlyn Beth, Gibsonia, Pennsylvania 15044 (US); CHILDS, II, Christopher Marshall, Farmington, West Virginia 26571 (US); WASHBURN, Newell Raymond, Pittsburgh, Pennsylvania 15217 (US)
(74) Representative: f & e patent
(86) International application number: PCT/US2023/064910
(87) International publication number: WO 2023/192804

(56) References cited:
- WO-A1-2021/023685
- US-A1- 2008 052 023
- US-A1- 2021 201 494
- KARNIADAKIS GEORGE EM ET AL: "Physics-informed machine learning", NATURE REVIEWS PHYSICS, vol. 3, no. 6, 24 May 2021 (2021-05-24), pages 422 - 440, XP093005789, Retrieved from the Internet <URL:https://www.nature.com/articles/s42254-021-00314-5> [retrieved on 20230719], DOI: 10.1038/s42254-021-00314-5

## Description

### TECHNICAL FIELD

The present disclosure relates generally to coatings and more specifically to techniques for color matching.

### BACKGROUND

Modern coatings provide various functions in industry and society. For example, vehicles and other types of machinery may be coated using paints or various other coatings in order to protect metal components from the elements (e.g., from rust) or to provide aesthetic visual effects. Properties of a coating (e.g., color, visual effects, texture, etc.) may be determined, in part, based on a chemical composition of the coating. In some cases, a coating may be manufactured to match an existing coating of a same color. Color matching techniques may be inefficient, time-consuming, or inaccurate. Accordingly, there are many opportunities for new methods and systems that improve techniques for color matching coatings.

US 2008/052023 A1 relates to a method for color matching a reference color formulation to a defined color shade standard. WO 2021/023685 A1 refers to a method and a system for matching and adjusting pigmentation of a sample coating to a target coating. US 2021/201494 A1 is directed to coatings technology and more particularly to systems and methods for matching color and appearance of target coatings. KARNIADAKIS GEORGE EM ET AL, "Physics-informed machine learning", 24 May 2021 (2021-05-24), Vol. {0} 3, No. {0} 6, page 422-440, DOl: 10.1038/s42254-021-00314-5, reviewes some of the prevailing trends in embedding physics into machine learning, present some of the current capabilities and limitations and discuss diverse applications of physics-informed learning both for forward and inverse problems, including discovering hidden physics and tackling high-dimensional problems.

### SUMMARY

Disclosed systems may include one or more processors and one or more computer-readable media. The computer-readable media may have executable instructions stored thereon that, when executed at the one or more processors, configure the computer system to perform various acts. The system may receive, from a spectrophotometer, a color measurement of a first coating, wherein the color measurement corresponds with a first color curve. Additionally, the system may process, with a physics-informed machine learning algorithm, information derived from the first color curve, wherein a radiative transfer function acts as a regularization agent that limits a space of admissible solutions within the physics-informed machine learning algorithm. The system may also generate, from an output of the physics-informed machine learning algorithm, a set of one or more color components that, if mixed, correspond to the first color curve.

Additionally or alternatively, disclosed computer-implemented methods may include receiving, from a spectrophotometer, a color measurement of a first coating, wherein the color measurement corresponds with a first color curve. Additionally, the computer-implemented method may include processing, with a physics-informed machine learning algorithm, information derived from the first color curve, wherein a radiative transfer function acts as a regularization agent that limits a space of admissible solutions within the physics-informed machine learning algorithm. Further, the computer-implemented method may include generating, from an output of the physics-informed machine learning algorithm, a set of one or more color components that, if mixed, correspond to the first color curve.

Additionally or alternatively, disclosed non-transitory computer-readable medium may comprise one or more computer-readable storage media having stored thereon computer-executable instructions that, when executed at a processor, cause a computer system to perform a method for color matching. The method may include receiving, from a spectrophotometer, a color measurement of a first coating, wherein the color measurement corresponds with a first color curve. Additionally, the method may include processing, with a physics-informed machine learning algorithm, information derived from the first color curve, wherein a radiative transfer function acts as a regularization agent that limits a space of admissible solutions within the physics-informed machine learning algorithm. Further, the method may include generating, from an output of the physics-informed machine learning algorithm, a set of one or more color components that, if mixed, correspond to the first color curve.

Additional features and advantages of exemplary implementations of the disclosure will be set forth in the description which follows, and in part will be obvious from the description, or may be learned by the practice of such exemplary implementations. The features and advantages of such implementations may be realized and obtained by means of the instruments and combinations particularly pointed out in the appended claims. These and other features will become more fully apparent from the following description and appended claims or may be learned by the practice of such exemplary implementations as set forth hereinafter.

### BRIEF DESCRIPTION OF THE DRAWINGS

In order to describe the manner in which the above recited and other advantages and features of the disclosure can be obtained, a more particular description of the disclosure briefly described above will be rendered by reference to specific embodiments thereof, which are illustrated in the appended drawings. Understanding that these drawings depict only typical embodiments of the disclosure and are not therefore to be considered to be limiting of its scope, the disclosure will be described and explained with additional specificity and detail through the use of the accompanying drawings described below.
Figure 1 illustrates a schematic of a system for matching color.
Figures 2 illustrates a schematic for a computer system for executing instructions.
Figure 3 illustrates a flow chart of a system for color matching.
Figure 4 illustrates a flow chart of steps for color matching.
Figure 5 illustrates a flow chart of a step for color matching.
Figure 6 illustrates a flow chart of another step for color matching.

### DETAILED DESCRIPTION

Disclosed systems, methods, or apparatus are configured to perform color matching. Coatings provide various functions, such as for protection or to provide an aesthetic visual effect. Coatings may be represented as recipes (e.g., color recipes or chemical formulae), which may indicate color components. As used herein, "color components" comprise chemical components within a coating formula. Examples of color components include toners, color pigments, effect pigments, base coatings, stains, dyes, etc. A process for determining a color recipe may include using a spectrophotometer to take measurements of a physical panel (e.g., a spray out panel, an automobile panel, an airplane panel, a boat hull, an architectural wall, etc. ) which is coated with a coating. The process may include using the measurements to determine a formula or recipe for the coating. The process may include creating a coating using the determined formula and iteratively spraying out and adjusting the formula to produce a coating which matches the coating of the physical panel. In some cases, a process for determining a color recipe may be inefficient, inaccurate, or may use a large quantity of resources or time. Accordingly, it may be beneficial to implement techniques for color matching as described herein.

A system (e.g., a computer system) for color matching may be implemented by a system including one or more processors and computer-readable media. For example, the computer-readable media may have stored thereon executable instructions which, if executed, configure the system to identify a coating color. For example, a computer system may receive a color measurement of a first coating; the measurement taken using a spectrophotometer. The coating may include at least one color property and at least one effect property. For example, the coating may be associated with a color and one or more visual effects (e.g., metallic, non-metallic, matte, etc.); though, some coatings may only include color features and may not include any visual effects. Measuring the coating with a spectrophotometer may result in a set of spectral data (e.g., an optical characterization) representing the coating.

A disclosed system may receive, from a spectrophotometer, a color measurement of a first coating, wherein the color measurement corresponds with a first color curve. Additionally, the system may process, with a physics-informed machine learning algorithm, information derived from the first color curve, wherein a radiative transfer function acts as a regularization agent that limits a space of admissible solutions within the physics-informed machine learning algorithm. The system may also generate, from an output of the physics-informed machine learning algorithm, a set of one or more color components that, if mixed, correspond to the first color curve. The resulting set of one or more color components can be displayed on a user interface for a user or sent directly to a formulation machine for creating of the coating. As such, in some configurations the physics-informed machine learning algorithm is able to generate proposed color components based upon a single color curve from a target coating.

As used herein a "physics-informed machine learning algorithm" comprises a machine learning algorithm that is embedded with knowledge of one or more physical laws that govern a data set received by the machine learning algorithm. As used herein a "radiative transfer function" comprises a mathematical function relating to the physical phenomenon of radiation propagation incident to a medium. For example, a radiative transfer function may comprise an algorithm derived from the Kubelka-Munk theory relating to the appearance of coating on a substrate. Additionally, as used herein a "regularization agent" comprises one or more physical laws that are used within a physics-informed machine learning algorithm to limit the space of admissible solution within and/or from the physics-informed machine learning algorithm. For example, a Kubelka-Munk algorithm may function as a regularization agent by providing one or more ranges (also referred to herein as "spaces") of valid response and/or intermediate results for analyzing a color coating. As such, the Kubelka-Munk algorithm may be embedded within the physics-informed machine learning algorithm to aid the physics-informed machine learning algorithm in calculating an acceptable answer and/or to prevent the physics-informed machine learning algorithm from providing a physically impossible answer.

In some configurations, the system may further determine, with a radiative transfer function (such as a Kubelka-Munk function), a second color curve for the first coating based at least in part on the first color curve. As used herein, a Kubelka-Munk function may comprise any algorithm that is derived based upon principles of the Kubelka-Munk theory. The system may process, with the physics-informed machine learning algorithm, the first color curve and the second color curve. Additionally, the system may generate, from the physics-informed machine learning algorithm, a third color curve based upon the first color curve and the second color curve.

Further, generating, from the physics-informed machine learning algorithm, the set of one or more color components that, if mixed, correspond to the first color curve may comprise identifying the set of one or more color components that, if mixed, correspond to the third color curve. Additionally, generating the set of one or more color components may comprise outputting a color recipe for the first coating, the color recipe comprising the set of one or more color components associated with the third color curve.

Additionally or alternatively, identifying the set of one or more components may include selecting a subset of random components and adjusting the subset incrementally until the second color curve satisfies an accuracy threshold relative to the first color curve. For example, the system may compute reflectance values according to Kubelka-Munk color theory and may input the reflectance values to the machine learning model to adjust the subset of random components. Similarly, the system may adjust concentrations associated with the one or more components incrementally such that the second color curve is based on adjusting the concentrations.

In some implementations, the system may convert data of the color measurement to three-dimensional color coordinates (e.g., in a CIELab color space including a lightness value (L*), red/green value (a*), and a blue/yellow value (b*)). Such conversion may utilize a number of different conversion methods known in the art, including, but not limited to utilizing spectrophotometers that automatically provide CIELab values, the CIE color matching functions, look-up tables, or a sum of Gaussian functions. Accordingly, the system may select components which surround the first coating in the color space (e.g., having coordinates which satisfy a distance threshold from the coordinates associated with the color measurement). In some implementations, the machine learning model may use a genetic algorithm, a gradient descent optimization process, a reinforcement learning process, a differential evolution optimization process, or any combination thereof.

The system may output (e.g., display to a user, send to a user computing device, etc.) a color recipe which includes the set of components. The system may implement a set of operating rules which limit a number of effect pigments or components associated with the color recipe. For example, the color recipe may be limited to ten components such that it includes less than or equal to ten components or effect pigments. The system may add an indication of the data associated with the first coating (e.g., the color measurement) and the color recipe to a set of data used to train the machine learning model (e.g., a set of historical coated panel data).

Various aspects of the present disclosure may be implemented to realize one or more potential advantages. For example, a system may use a hierarchical machine learning model in which Kubelka Munk theory is used as a first approximation of the reflectance curve and then estimated reflectance values from a historical set of coated panels are used as input to the machine learning model. Such a machine learning model may enable more efficient, more accurate, or less time-consuming color matching procedures, among other benefits.

Additional aspects of the disclosure, including examples, advantages, etc. will be described in the context of a scheme diagram, system diagrams, and method flows. As used throughout this application, unless stated otherwise, singular aspects of the disclosed and claimed invention include plural aspects and vice versa.

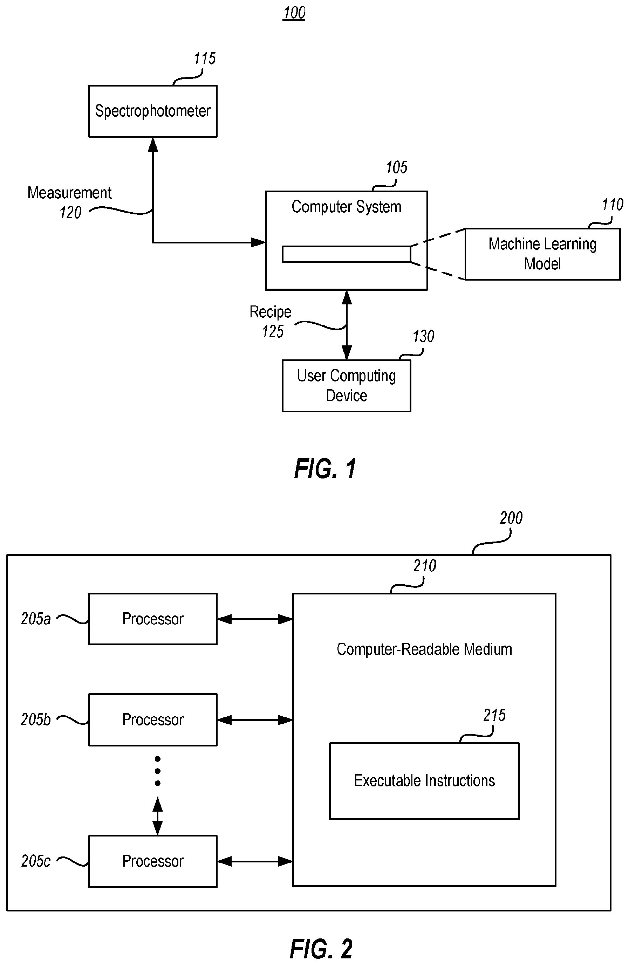

Figure 1 illustrates a schematic 100 of a system for matching color. The schematic 100 may include a computer system 105 associated with a machine learning model 110 (e.g., stored on or in communication with the computer system 105). The schematic 100 shows a spectrophotometer 115 and a user computing device 130 which share information or otherwise communicate with the computer system 105. The schematic 100 may include additional components or devices which may share data or perform functions not illustrated with respect to Figure 1. The schematic 100 may be employed as part of a process for color matching.

Color matching may be performed if an entity (e.g., a third party, a user, an automotive shop, and architectural firm, a manufacturer, etc.) requests a coating which matches a previously-existing coating. For example, if an automotive shop repairs a car having a previously applied coating (e.g., due to collision damage) and does not have the coating or a formula or recipe for the coating, the automotive shop may request a matched coating. The requested coating may include a number of different components or color pigments as well as effect pigments which provide a visual effect (e.g., metallic, non-metallic, matte, gloss, etc.).

To provide a matched coating or a corresponding color recipe, a first party may take measurements of the previously applied coating (e.g., which may be on a physical panel or vehicle) using a spectrophotometer. Additionally or alternatively, the automotive shop may take measurements using a spectrophotometer and may send the resulting measurement data to the first party to be processed. As described herein, the computer system 105 may implement the machine learning model 110, which may be a physics-informed machine learning algorithm. The machine learning model 110 may have been trained using a set of historical spray out panel data having known color curves and recipes. Accordingly, the machine learning model 110 may be able to determine color curves and corresponding toner concentrations or formulae using spectral data measurements taken with, for example, the spectrophotometer 115.

The computer system 105 may receive a measurement 120 taken using the spectrophotometer 115. The measurement 120 may be associated with a first coating which includes at least one color property and at least one effect property (e.g., includes at least one type of toner). The measurement 120 may be an example of an optical characterization of the first coating represented as spectral data output from the spectrophotometer 115. In some examples, the first coating may be associated with a previously coated physical panel or item (e.g., a vehicle).

The computer system 105 may determine a first color curve for the first coating based on the measurement 120. The first color curve may be an example of a reflectance curve or spectra that is representative of the first coating (e.g., of the color components present in the first coating). Using a radiative transfer function, the computer system 105 may identify a second set of color components that correspond to a second color curve. As such, the second color curve is based upon the first color curve through the radiative transfer function. Both the first color curve and the second color curve may then be processed by the machine learning model 110 (e.g., the physics-informed machine learning algorithm).

In some examples, the computer system 105 may (e.g., using the machine learning model 110) compute a reflectance curve for each toner such that identifying the set of components is based on the computing the reflectance curves. For example, the computer system 105 may apply a Gaussian process regression model to data associated with each toner (e.g., spectral data for each toner) to determine the reflectance curves. In some implementations, the computer system 105 may select a subset of random components and compute reflectance values for each toner of the subset of random components according to Kubelka-Munk color theory. The computer system 105 may use the reflectance values as input for the machine learning model 110 which may adjust the subset of random components incrementally until the resulting, second color curve satisfies an accuracy threshold relative to the first color curve. Adjusting the subset of random components may include selecting different components or adjusting toner concentrations. In some implementations, the computer system 105 may determine multiple color curves in parallel based on analyzing multiple components, toner concentrations, combinations of components, etc. For example, the computer system 105 may use different processors or other technologies to compute multiple color curves in parallel. Similarly, the multiple components, toner concentrations, combinations of components, etc. which the computer system 105 uses may be based on the historical coating data used to train the machine learning model 110. In some configurations, the machine learning model 110 may use a genetic algorithm, a gradient descent optimization process, a reinforcement learning process, or a differential evolution optimization process.

The computer system 105 may convert data associated with the color measurement 120 (e.g., the spectral data) to three-dimensional coordinates in a color space (e.g., a CIELab color space). Accordingly, the computer system 105 may select components to test based on coordinates in the color space. For example, the computer system 105 may select components which satisfy a distance threshold with respect to the coordinates of the measurement 120 (e.g., which surround the coordinates of the measurement 120 in the color space).

The computer system 105 may output the set of components which match the measurement 120 to the user computing device 130 as a recipe 125 (e.g., a color recipe or formula). The recipe 125 may indicate the components and related toner concentrations as well as identifier information associated with the resulting coating. In some examples, the computer system 105 may implement a set of operating rules including a limit on a number of effect pigments or components associated with the recipe 125. For example, the computer system 105 may limit the recipe 125 to less than or equal to ten components or effect pigments. In some implementations, the computer system 105 may add an indication of the data associated with the first coating and the color recipe to a set of data used to train the machine learning model, enabling the machine learning model 110 to develop a higher level of efficiency or accuracy as more color match procedures are performed. Implementing aspects of the schematic 100 may enable color match procedures which are more efficient, more accurate, or less time-consuming, among other benefits.

Figure 2 illustrates an example of a computer system 200 that supports techniques for color matching, in accordance with various aspects of the present disclosure. The computer system 200 may implement aspects of a schematic 100 as described with reference to Figure 1. The computer system 200 may include one or more processors 205 (e.g., a processor 205a, a processor 205b, a processor 205c, etc.), a computer-readable medium 210 and a set of executable instructions 215. The one or more processors 205 may include general purpose processors, central processing units, graphics processing units, digital signal processors, application specific integrated circuits, field-programmable gate arrays, or any combination thereof. The computer system 200 may be an example of means for performing methods and functions of the present disclosure as described herein.

For example, the set of executable instructions 215 may include instructions which, when executed by the one or more processors 205, may cause the computer system 200 to perform at least the following: receiving, from a spectrophotometer, a color measurement of a first coating, wherein the color measurement corresponds with a first color curve; processing, with a physics-informed machine learning algorithm, information derived from the first color curve, wherein a radiative transfer function acts as a regularization agent that limits a space of admissible solutions within the physics-informed machine learning algorithm; and generating, from an output of the physics-informed machine learning algorithm, a set of one or more color components that, if mixed, correspond to the first color curve. Implementing aspects of the system 200 may lead to a higher efficiency or a higher accuracy of color matching processes, among other benefits.

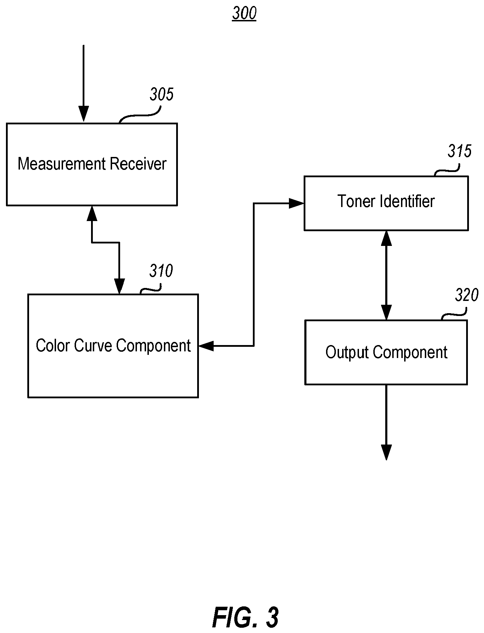

Figure 3 illustrates an example of a system 300 that supports techniques for color matching, in accordance with various aspects of the present disclosure. In some examples, aspects of the system 300 may implement aspects of a schematic 100 or a system 200, as described with reference to Figures 1 and 2. For example, the system 300 may be implemented by or otherwise associated with one or more processors or one or more computer-readable media, as described herein. The system 300 may include a measurement receiver 305, a color curve component 310, a toner identifier 315, an output component 320, or any combination thereof. The components of the system 300 as described herein may communicate or otherwise share information as illustrated in Figure 3 or in other ways, such as between components not illustrated. In some examples, the system 300 may include additional components or components may be removed or altered. The system 300 may be an example of means for performing methods and functions of the present disclosure as described herein.

The measurement receiver 305 may comprise a network connection, a wireless connection, a wired connection, or some other conventional computer I/O interface for communicating between a spectrophotometer and a computer. The measurement received 305 may receive, from a spectrophotometer, a color measurement of a first coating. The color measurement corresponds with a first color curve.

The toner identifier 315 may comprise a processing unit, such as those described herein that are conventionally used to process digital and/or analog data. The toner identifier 315 processes, with a physics-informed machine learning algorithm, information derived from the first color curve. Additionally or alternatively, the toner identified 315 may process both the first color curve and a second color curve with the physics-informed machine learning algorithm. A color curve component 310 may optionally, calculate the second color curve, using a radiative transfer function, from the first color curve. Additionally, a radiative transfer function acts as a regularization agent that limits a space of admissible solutions within the physics-informed machine learning algorithm.

The toner identifier 315 may also apply a Gaussian process regression model to data associated with each toner in the second color curve, in which computing the reflectance curves is based at least in part on applying the Gaussian process regression model. In some examples, the toner identifier 315 may convert data associated with the color measurement to three-dimensional coordinates in a color space (e.g., a CIELab color space) and may select one or more color components having coordinates that surround the first coating in the color space based on converting the color measurement of the first coating. The toner identifier 315 may, in some examples, determine multiple color curves in parallel based on analyzing multiple colors components, including toner concentrations, combinations of components, or any combination thereof. In some implementations, analyzing the multiple color components may be based on historical coating spray-outs.

In some configurations, the toner identifier 315 may select a subset of random components and adjust each subset of random components incrementally until the second color curve satisfies an accuracy threshold relative to the first color curve. For example, the toner identifier 315 may compute reflectance values according to Kubelka-Munk color theory. The toner identifier 315 may input the reflectance values to the machine learning model to adjust each subset of random components incrementally until the second color curve satisfies an accuracy threshold relative to the first color curve. The toner identifier 315 may adjust concentrations associated with the one or more components incrementally, in which the second color curve is based at least in part on adjusting the concentrations. The output component 320 may output a color recipe for the first coating, the color recipe including the set of one or more components.

The machine learning model may be a hierarchical machine learning model in which Kubelka-Munk color theory is used as a first approximation of the reflectance curve and then estimated reflectance values from a historical set of coated panels are used as input to the machine learning model. The machine learning model may use a genetic algorithm. Similarly, the machine learning model may use a gradient descent optimization process, a reinforcement learning process, a differential evolution optimization process, or any combination thereof. The system 300 may implement a set of operating rules including a limit on a number of effect pigments associated with the color recipe. For example, the color recipe may include less than or equal to ten components or effect pigments. Implementing aspects of the system 300 may lead to a higher efficiency or a higher accuracy of color matching processes, among other benefits.

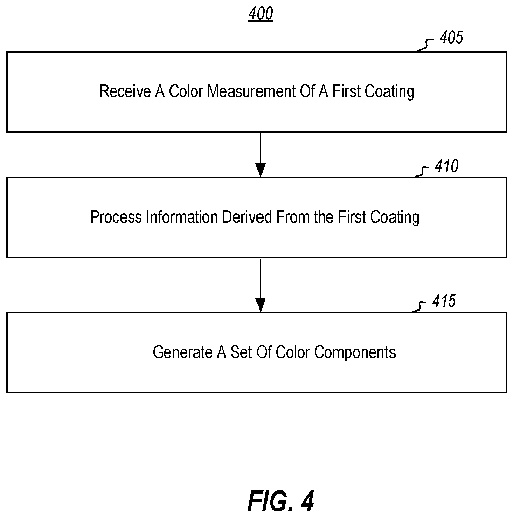

Figure 4 illustrates an example of a method flow 400 that supports techniques for color matching. In some examples, the method flow 400 may be implemented by or otherwise associated with a schematic 100, a system 200 or a system 300, as described with reference to Figures 1-3. For example, the method flow 400 may correspond to executable instructions stored on computer-readable media which configure a system (e.g., a computer system having one or more processors) to perform various acts. The steps illustrated with respect to the method flow 400 may be performed in a different order than shown or steps may be added or removed.

At 405, the method flow 400 may include receive, from a spectrophotometer, a color measurement of a first coating, wherein the color measurement corresponds with a first color curve.

At 410, the method flow 400 may include process, with a physics-informed machine learning algorithm, information derived from the first color curve, wherein a radiative transfer function acts as a regularization agent that limits a space of admissible solutions within the physics-informed machine learning algorithm.

At 415, the method flow 400 may include generating, from an output of the physics-informed machine learning algorithm, a set of one or more color components that, if mixed, correspond to the first color curve. As such, the physics-informed machine learning algorithm may generate a coating recipe based upon a reading of a first coating.

In some implementations, the method flow 400 may include additional steps not illustrated. For example, the method flow 400 may include determining a second color curve for the first coating based at least in part on the first color curve. The method flow may further include processing, with the physics-informed machine learning algorithm, the first color curve and the second color curve. Further, the method flow may include generating from the physics-informed machine learning algorithm, a third color curve based upon the first color curve and the second color curve. The third color curve is used by the physics-informed machine learning algorithm generate the one or more color components, that if mixed, correspond to the first color curve.

In some examples, identifying the set of one or more components includes selecting a subset of random components and adjusting each subset of random components incrementally until the second color curve satisfies an accuracy threshold relative to the first color curve. In some implementations, adjusting each subset may include computing reflectance values according to Kubelka-Munk color theory. The method flow 400 may include inputting the reflectance values to the machine learning model to adjust each subset of random components incrementally until the second color curve satisfies an accuracy threshold relative to the first color curve. In some examples, identifying the set of one or more components includes adjusting concentrations associated with the one or more components incrementally, in which the second color curve is based on adjusting the concentrations.

In some implementations, the machine learning model may use a genetic algorithm. Similarly, the machine learning model may use a gradient descent optimization process, a reinforcement learning process, a differential evolution optimization process, or any combination thereof. In some examples, the machine learning model includes a hierarchical machine learning model in which Kubelka-Munk color theory is used as a first approximation of the reflectance curve and then estimated reflectance values from a historical set of coated panels are used as input to the machine learning models. In some examples, the method flow 400 may include adding an indication of the data associated with the first coating and the color recipe to a set of data used to train the machine learning model. Implementing aspects of the method flow 400 may lead to a higher efficiency or a higher accuracy of color matching processes, among other benefits.

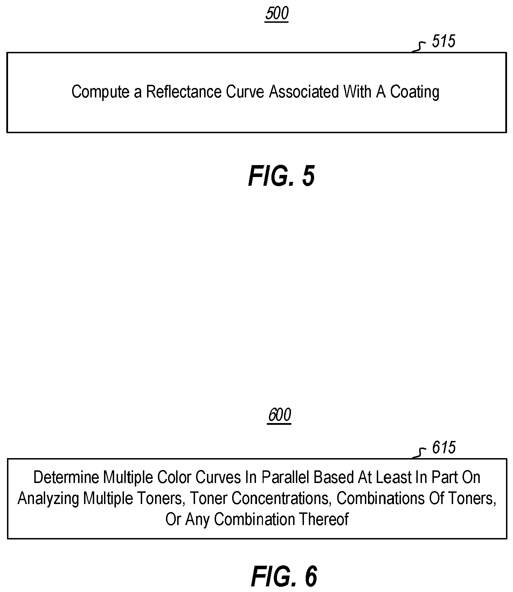

Figure 5 illustrates an example of a method flow 500 that supports techniques for color matching, in accordance with aspects of the present disclosure. In some examples, the method flow 400 may be implemented by or otherwise associated with a schematic 100, a system 200, a system 300 or a method flow 400 as described with reference to Figures 1-4. For example, the method flow 500 may correspond to executable instructions stored on computer-readable media which configure a system (e.g., a computer system having one or more processors) to perform various acts. The steps illustrated with respect to the method flow 500 may be performed in a different order than shown or steps may be added or removed.

In some examples, the method flow 500 may be performed in correspondence with a method flow 400, as described with reference to Figure 4. For example, in accordance with steps 405 through 410 of the method flow 400, the method flow 500 may include receiving a color measurement of a first coating, the measurement taken using a spectrophotometer, the first coating including at least one color property and at least one effect property. The method flow 510 may also include determining a first color curve for the first coating based on the color measurement.

At 515, the method flow 500 may include computing a reflectance curve associated with the first coating, in which identifying the set of one or more components is based on computing the reflectance curve associated with the first coating. In some implementations, computing the reflectance curve may include applying a Gaussian process regression model to data associated with each toner, in which computing the reflectance curve is based on applying the Gaussian process regression model.

The method flow 500 may, in accordance with 420 of the method flow 400, also include outputting a color recipe for the first coating, the color recipe including the set of one or more components. Implementing aspects of the method flow 500 may lead to a higher efficiency or a higher accuracy of color matching processes, among other benefits.

Figure 6 illustrates an example of a method flow 600 that supports techniques for color matching, in accordance with aspects of the present disclosure. In some examples, the method flow 400 may be implemented by or otherwise associated with a schematic 100, a system 200, a system 300, a method flow 400 or a method flow 500 as described with reference to Figures 1-5. For example, the method flow 600 may correspond to executable instructions stored on computer-readable media which configure a system (e.g., a computer system having one or more processors) to perform various acts. The steps illustrated with respect to the method flow 600 may be performed in a different order than shown or steps may be added or removed.

In some examples, the method flow 600 may be performed in correspondence with a method flow 400 or a method flow 500, as described with reference to Figures 4 and 5. For example, in accordance with steps 405 through 410 of the method flow 400, the method flow 600 may include receiving a color measurement of a first coating, the measurement taken using a spectrophotometer, the first coating including at least one color property and at least one effect property. The method flow 610 may also include determining a first color curve for the first coating based on the color measurement.

The method flow 600 may also include computing a reflectance curve associated with each toner, in which identifying the set of one or more components is based on computing the reflectance curve associated with each toner. In some implementations, computing the reflectance curve may include applying a Gaussian process regression model to data associated with each toner, in which computing the reflectance curve is based on applying the Gaussian process regression model.

In some examples, at 615, the method flow 600 may also include determining multiple color curves for each toner in parallel based on analyzing multiple components, toner concentrations, combinations of components, or any combination thereof. In such examples, identifying the set of one or more components is based on determining the multiple color curves in parallel. In some implementations, analyzing multiple components, toner concentrations, combinations of components, or any combination thereof is based on historical coating spray outs. As such, a first color curve may be descriptive of an entire coating and/or a first color curve may be descriptive of a single toner within a coating.

The method flow 600 may, in accordance with 420 of the method flow 400, also include outputting a color recipe for the first coating, the color recipe including the set of one or more components. Implementing aspects of the method flow 600 may lead to a higher efficiency or a higher accuracy of color matching processes, among other benefits.

Although the subject matter has been described in language specific to structural features and/or methodological acts, it is to be understood that the subject matter defined in the appended claims is not necessarily limited to the described features or acts described above, or the order of the acts described above. Rather, the described features and acts are disclosed as example forms of implementing the claims.

The present disclosure may comprise or utilize a special-purpose or general-purpose computer system that includes computer hardware, such as, for example, one or more processors and system memory, as discussed in greater detail below. Embodiments within the scope of the present disclosure also include physical and other computer-readable media for carrying or storing computer-executable instructions and/or data structures. Such computer-readable media can be any available media that can be accessed by a general-purpose or special-purpose computer system. Computer-readable media that store computer-executable instructions and/or data structures are computer storage media. Computer-readable media that carry computer-executable instructions and/or data structures are transmission media. Thus, by way of example, and not limitation, embodiments of the disclosure can comprise at least two distinctly different kinds of computer-readable media: computer storage media and transmission media.

Computer storage media (e.g., including non-transitory computer-readable media) are physical storage media that store computer-executable instructions and/or data structures. Physical storage media include computer hardware, such as RAM, ROM, EEPROM, solid state drives ("SSDs"), flash memory, phase-change memory ("PCM"), optical disk storage, magnetic disk storage or other magnetic storage devices, or any other hardware storage device(s) which can be used to store program code in the form of computer-executable instructions or data structures, which can be accessed and executed by a general-purpose or special-purpose computer system to implement the disclosed functionality of the disclosure.

Transmission media can include a network and/or data links which can be used to carry program code in the form of computer-executable instructions or data structures, and which can be accessed by a general-purpose or special-purpose computer system. A "network" is defined as one or more data links that enable the transport of electronic data between computer systems and/or modules and/or other electronic devices. When information is transferred or provided over a network or another communications connection (either hardwired, wireless, or a combination of hardwired or wireless) to a computer system, the computer system may view the connection as transmission media. Combinations of the above should also be included within the scope of computer-readable media.

Further, upon reaching various computer system components, program code in the form of computer-executable instructions or data structures can be transferred automatically from transmission media to computer storage media (or vice versa). For example, computer-executable instructions or data structures received over a network or data link can be buffered in RAM within a network interface module (e.g., a "NIC"), and then eventually transferred to computer system RAM and/or to less volatile computer storage media at a computer system. Thus, it should be understood that computer storage media can be included in computer system components that also (or even primarily) utilize transmission media.

Computer-executable instructions comprise, for example, instructions and data which, when executed at one or more processors, cause a general-purpose computer system, special-purpose computer system, or special-purpose processing device to perform a certain function or group of functions. Computer-executable instructions may be, for example, binaries, intermediate format instructions such as assembly language, or even source code.

Those skilled in the art will appreciate that the disclosure may be practiced in network computing environments with many types of computer system configurations, including, personal computers, desktop computers, laptop computers, message processors, hand-held devices, multiprocessor systems, microprocessor-based or programmable consumer electronics, network PCs, minicomputers, mainframe computers, mobile telephones, PDAs, tablets, pagers, routers, switches, and the like. The disclosure may also be practiced in distributed system environments where local and remote computer systems, which are linked (either by hardwired data links, wireless data links, or by a combination of hardwired and wireless data links) through a network, both perform tasks. As such, in a distributed system environment, a computer system may include a plurality of constituent computer systems. In a distributed system environment, program modules may be located in both local and remote memory storage devices.

Those skilled in the art will also appreciate that the disclosure may be practiced in a cloud-computing environment. Cloud computing environments may be distributed, although this is not required. When distributed, cloud computing environments may be distributed internationally within an organization and/or have components possessed across multiple organizations. In this description and the following claims, "cloud computing" is defined as a model for enabling on-demand network access to a shared pool of configurable computing resources (e.g., networks, servers, storage, applications, and services). The definition of "cloud computing" is not limited to any of the other numerous advantages that can be obtained from such a model when properly deployed.

A cloud-computing model can be composed of various characteristics, such as on-demand self-service, broad network access, resource pooling, rapid elasticity, measured service, and so forth. A cloud-computing model may also come in the form of various service models such as, for example, Software as a Service ("SaaS"), Platform as a Service ("PaaS"), and Infrastructure as a Service ("laaS"). The cloud-computing model may also be deployed using different deployment models such as private cloud, community cloud, public cloud, hybrid cloud, and so forth.

Some embodiments, such as a cloud-computing environment, may comprise a system that includes one or more hosts that are each capable of running one or more virtual machines. During operation, virtual machines emulate an operational computing system, supporting an operating system and perhaps one or more other applications as well. In some embodiments, each host includes a hypervisor that emulates virtual resources for the virtual machines using physical resources that are abstracted from view of the virtual machines. The hypervisor also provides proper isolation between the virtual machines. Thus, from the perspective of any given virtual machine, the hypervisor provides the illusion that the virtual machine is interfacing with a physical resource, even though the virtual machine only interfaces with the appearance (e.g., a virtual resource) of a physical resource. Examples of physical resources including processing capacity, memory, disk space, network bandwidth, media drives, and so forth.

## Claims

1. A system (200) for color matching, comprising:
one or more processors (205); and
one or more computer-readable media having stored thereon executable instructions (215) that, when executed by the one or more processors (205), configure the system to:
receive (400), from a spectrophotometer (115), a color measurement (120) of a first coating, wherein the color measurement (120) comprises a first color curve;
process (410), with a physics-informed machine learning algorithm, information derived from the first color curve, wherein a radiative transfer function acts as a regularization agent that limits a space of admissible solutions within the physics-informed machine learning algorithm; and
generate (415), from an output of the physics-informed machine learning algorithm, a set of one or more color components that, if mixed, correspond to the first coating.

2. The system (200) as recited in claim 1, wherein the one or more computer-readable media further include executable instructions (215) that, when executed at a processor (205), configure the system to:
determine a second color curve for the first coating based at least in part on the first color curve;
process, with the physics-informed machine learning algorithm, the first color curve and the second color curve; and
generate, from the physics-informed machine learning algorithm, a third color curve based upon the first color curve and the second color curve, preferably wherein the executable instructions (215) for generating, from the physics-informed machine learning algorithm, the set of one or more color components that, if mixed, correspond to the first coating comprise instructions that, when executed at a processor (205), configure the system to:
identify the set of one or more color components that, if mixed, correspond to the third color curve; and
output a color recipe for the first coating, the color recipe comprising the set of one or more color components.

3. The system (200) as recited in any one of claims 1 or 2, wherein the executable instructions (215) for processing, with a physics-informed machine learning algorithm, information derived from the first color curve comprise instructions that, when executed at a processor (205), configure the system to:
process, with a physics-informed machine learning algorithm, the first color curve and the second color curve, wherein the radiative transfer function acts as the regularization agent that limits the space of admissible solutions within the physics-informed machine learning algorithm, and/or wherein the executable instructions (215) for generating the set of one or more color components comprise instructions that, when executed at a processor (205), configure the system to:
compute a reflectance curve associated with each toner, wherein the reflectance curve is used to identifying the set of one or more color components,
preferably wherein the executable instructions (215) for computing the reflectance curve comprise instructions that, when executed at a processor (205), configure the system to:
apply a Gaussian process regression model to data associated with each toner, wherein computing the reflectance curve is based at least in part on applying the Gaussian process regression model.

4. The system (200) as recited in any one of claims 1 to 3, wherein the executable instructions (215) for generating the set of one or more color components comprise instructions that, when executed at a processor (205), configure the system to:
convert data associated with the color measurement (120) to three-dimensional coordinates in a color space; and
select one or more components having coordinates that surround the first coating in the color space based at least in part on converting the color measurement (120) of the first coating,
preferably wherein the color space comprises a CIELab color space.

5. The system (200) as recited in any one of claims 1 to 4, wherein the executable instructions (215) for generating the set of one or more color components comprise instructions that, when executed at a processor (205), configure the system to:
Determine (615) multiple color curves in parallel based at least in part on analyzing multiple components, toner concentrations, combinations of components, or any combination thereof,
preferably wherein analyzing multiple components, toner concentrations, combinations of components, or any combination thereof is based at least in part on historical coating spray outs.

6. The system (200) of any one of claims 1 to 5, wherein the physics-informed machine learning algorithm comprises a machine learning algorithm using the Kubelka-Munk theory as the regularization agent.

7. The system (200) of any one of claims 1 to 6, wherein a Kubelka-Munk function is used as the radiative transfer function for determining the first color curve and/or the second color curve.

8. The system (200) of any one of claims 1 to 7, wherein the processing, with a physics-informed machine learning algorithm, of the information derived from the first color curve includes:
determine a second color curve for the first coating based at least in part on the first color curve, and
generate, from the physics-informed machine learning algorithm, a third color curve based upon the first color curve and the second color curve, and
wherein generating, from an output of the physics-informed machine learning algorithm a set of one or more color components that, if mixed, correspond to the third color curve instead of the first color curve, and further comprise output a color recipe for the first coating, the color recipe comprising the set of one or more color components, and/or
wherein the first color curve is a reflectance curve or spectra that is representative of the first coating,
preferably wherein identifying the set of components is based on the computing the reflectance curves.

9. The system (200) of any one of claims 1 to 8, wherein generate, from an output of the physics-informed machine learning algorithm a set of one or more color components further comprises:
select a subset of random components and adjust each subset of random components incrementally until the second color curve satisfies an accuracy threshold relative to the first color curve, and/or wherein the machine learning model (110) is a hierarchical machine learning model (110) in which Kubelka-Munk color theory is used as a first approximation of the reflectance curve and then estimated reflectance values from a historical set of coated panels are used as input to the machine learning model (110).

10. A computer-implemented method, executed on one or more processors (205), the computer-implemented method for color matching, comprising:
Receiving (405), from a spectrophotometer (115), a color measurement (120) of a first coating, wherein the color measurement (120) comprises a first color curve;
Processing (410), with a physics-informed machine learning algorithm, information derived from the first color curve, wherein a radiative transfer function acts as a regularization agent that limits a space of admissible solutions within the physics-informed machine learning algorithm; and
Generating (415), from an output of the physics-informed machine learning algorithm, a set of one or more color components that, if mixed, correspond to the first coating.

11. The computer-implemented method as recited in claim 10, further comprising:
Determining a second color curve for the first coating based at least in part on the first color curve;
processing, with the physics-informed machine learning algorithm, the first color curve and the second color curve; and
generating, from the physics-informed machine learning algorithm, a third color curve based upon the first color curve and the second color curve, preferably wherein generating, from the physics-informed machine learning algorithm, that set of one or more color components that, if mixed, correspond to the first coating comprises:
identifying the set of one or more color components that, if mixed, correspond to the third color curve; and
outputting a color recipe for the first coating, the color recipe comprising the set of one or more color components.

12. The computer-implemented method as recited in any one of claims 10 to 11, wherein generating the set of one or more color components further comprise:
Computing (515) a reflectance curve associated with each toner, wherein identifying the set of one or more color components is based at least in part on computing (515) the reflectance curve associated with each toner, and/or wherein computing the reflectance curve comprises:
applying a Gaussian process regression model to data associated with each toner, wherein computing the reflectance curve is based at least in part on applying the Gaussian process regression model.

13. The computer-implemented method as recited in any one of claims 10 to 12, wherein generating the set of one or more color components comprises:
converting data associated with the color measurement (120) to three-dimensional coordinates in a color space; and
selecting one or more components having coordinates that surround the first coating in the color space based at least in part on converting the color measurement (120) of the first coating,
preferably wherein the color space comprises a CIELab color space.

14. The computer-implemented method as recited in any one of claims 10 to 13, wherein generating the set of one or more color components comprises:
determining (615) multiple color curves in parallel based at least in part on analyzing multiple components, toner concentrations, combinations of components, or any combination thereof, and/or wherein analyzing multiple components, toner concentrations, combinations of components, or any combination thereof is based at least in part on historical coating spray outs.

15. A non-transitory computer-readable medium comprising one or more computer-readable storage media having stored thereon computer-executable instructions (215) that, when executed at a processor (205), cause a computer system to perform a method for color matching, the method comprising:
Receiving (405), from a spectrophotometer (115), a color measurement (120) of a first coating, wherein the color measurement (120) corresponds with a first color curve;
Processing (410), with a physics-informed machine learning algorithm, information derived from the first color curve, wherein a radiative transfer function acts as a regularization agent that limits a space of admissible solutions within the physics-informed machine learning algorithm; and
Generating (415), from an output of the physics-informed machine learning algorithm, a set of one or more color components that, if mixed, correspond to the first coating.

## Patentansprüche

1. Ein System (200) zur Farbanpassung, enthaltend:
einen oder mehrere Prozessoren (205) und
ein oder mehrere computerlesbare Medien, auf denen ausführbare Befehle (215) gespeichert sind, die, wenn sie von dem einen oder den mehreren Prozessoren (205) ausgeführt werden, das System wie folgt konfigurieren:
Empfangen (400) einer Farbmessung (120) einer ersten Beschichtung von einem Spektralphotometer (115), wobei die Farbmessung (120) eine erste Farbkurve umfasst,
Verarbeiten (410) von Informationen, die aus der ersten Farbkurve abgeleitet wurden, mit einem physiktrainierten Algorithmus für maschinelles Lernen, wobei eine Strahlungstransferfunktion als Regulierungsmittel fungiert, das einen Raum zulässiger Lösungen innerhalb des physiktrainierten Algorithmus für maschinelles Lernen begrenzt, und Erzeugen (415) eines Satzes einer oder mehrerer Farbkomponenten, die, wenn sie gemischt werden, der ersten Beschichtung entsprechen, aus einer Ausgabe des physiktrainierten Algorithmus für maschinelles Lernen.

2. Das System (200) gemäß Anspruch 1, wobei das eine oder die mehreren computerlesbaren Medien ferner ausführbare Befehle (215) enthalten, die, wenn sie auf einem Prozessor (205) ausgeführt werden, das System wie folgt konfigurieren:
Bestimmen einer zweite Farbkurve für die erste Beschichtung basierend zumindest teilweise auf der ersten Farbkurve,
Verarbeiten der erste Farbkurve und der zweite Farbkurve mit dem physiktrainierten Algorithmus für maschinelles Lernen und
Erzeugen einer dritten Farbkurve auf der Grundlage der ersten Farbkurve und der zweiten Farbkurve aus dem physiktrainierten maschinellen Lernalgorithmus,
wobei bevorzugt die ausführbaren Befehle (215) zum Erzeugen des Satzes einer oder mehrerer Farbkomponenten, die, wenn sie gemischt werden, der ersten Beschichtung entsprechen, aus dem physiktrainierten Algorithmus für maschinelles Lernen, wenn die Befehle auf einem Prozessor (205) ausgeführt werden, das System wie folgt konfigurieren:
Identifizieren des Satzes einer oder mehrerer Farbkomponenten, die, wenn sie gemischt werden, der dritten Farbkurve entsprechen, und
Ausgeben einer Farbrezeptur für die erste Beschichtung, wobei die Farbrezeptur den Satz einer oder mehrerer Farbkomponenten enthält.

3. Das System (200) gemäß einem der Ansprüche 1 oder 2, wobei die ausführbaren Befehle (215) zum Verarbeiten von Informationen, die aus der ersten Farbkurve abgeleitet sind, mit einem physiktrainierten Algorithmus für maschinelles Lernen Befehle enthalten, die, wenn sie auf einem Prozessor (205) ausgeführt werden, das System wie folgt konfigurieren:
Verarbeiten der erste Farbkurve und die zweite Farbkurve mit einem physiktrainierten Algorithmus für maschinelles Lernen, wobei die Strahlungstransferfunktion als Regulierungsmittel fungiert, das den Raum zulässiger Lösungen innerhalb des physiktrainierten Algorithmus für maschinelles Lernen begrenzt, und/oder
wobei die ausführbaren Befehle (215) zum Erzeugen des Satzes einer oder mehrerer Farbkomponenten Befehle enthalten, die, wenn sie auf einem Prozessor (205) ausgeführt werden, das System wie folgt konfigurieren: Berechnen einer mit jedem Toner assoziierten Reflexionskurve , wobei die Reflexionskurve verwendet wird, um den Satz einer oder mehrerer Farbkomponenten zu identifizieren,
wobei bevorzugt die ausführbaren Befehle (215) zum Berechnen der Reflexionskurve Befehle enthalten, die, wenn sie auf einem Prozessor (205) ausgeführt werden, das System wie folgt konfigurieren:
Anwenden eines Regressionsmodells mit Gaußschen Prozessen auf Daten, die jedem Toner zugeordnet sind, wobei die Berechnung der Reflexionskurve zumindest teilweise auf der Anwendung des Regressionsmodells mit Gaußschen Prozessen basiert.

4. Das System (200) gemäß einem der Ansprüche 1 bis 3, wobei die ausführbaren Befehle (215) zum Erzeugen des Satzes einer oder mehrerer Farbkomponenten Befehle enthält, die, wenn sie auf einem Prozessor (205) ausgeführt werden, das System wie folgt konfigurieren:
Umwandeln von Daten, die mit der Farbmessung (120) verbundenen sind, in dreidimensionale Koordinaten in einem Farbraum und
Auswählen von einer oder mehreren Komponenten mit Koordinaten, die die erste Beschichtung im Farbraum umgeben, die zumindest teilweise auf der Umwandlung der Farbmessung (120) der ersten Beschichtung basieren, wobei der Farbraum bevorzugt einen CIELab-Farbraum umfasst.

5. Das System (200) gemäß einem der Ansprüche 1 bis 4, wobei die ausführbaren Befehle (215) zum Erzeugen des Satzes einer oder mehrerer Farbkomponenten Befehle enthalten, die, wenn sie auf einem Prozessor (205) ausgeführt werden, das System wie folgt konfigurieren:
parallele Bestimmung (615) mehrerer Farbkurven, die zumindest teilweise auf der Analyse mehrerer Komponenten, Tonerkonzentrationen,
Kombinationen von Komponenten oder einer beliebigen Kombination davon basieren,
wobei bevorzugt die Analyse mehrerer Komponenten, Tonerkonzentrationen, Kombinationen von Komponenten oder einer beliebigen Kombination davon zumindest teilweise auf historischen Beschichtungssprühergebnissen basiert.

6. Das System (200) nach einem der Ansprüche 1 bis 5, wobei der physiktrainierte Algorithmus für maschinelles Lernen einen Algorithmus für maschinelles Lernen umfasst, der die Kubelka-Munk-Theorie als Regulierungsmittel verwendet.

7. Das System (200) nach einem der Ansprüche 1 bis 6, wobei eine Kubelka-Munk-Funktion als Strahlungstransferfunktion zur Bestimmung der ersten Farbkurve und/oder der zweiten Farbkurve verwendet wird.

8. Das System (200) nach einem der Ansprüche 1 bis 7, wobei die Verarbeitung von den Informationen, die aus der ersten Farbkurve abgeleitet sind, mit einem physiktrainierten Algorithmus für maschinelles Lernen Folgendes beinhaltet:
Bestimmen einer zweiten Farbkurve für die erste Beschichtung, die zumindest teilweise auf der ersten Farbkurve basiert, und
Erzeugen einer dritten Farbkurve aus dem physiktrainierten Algorithmus für maschinelles Lernen auf der Grundlage der ersten Farbkurve und der zweiten Farbkurve und
wobei Erzeugen eines Satzes einer oder mehrerer Farbkomponenten, die, wenn sie gemischt werden, der dritten Farbkurve anstelle der ersten Farbkurve entsprechen, aus einer Ausgabe des physiktrainierten Algorithmus für maschinelles Lernen, und ferner enthaltend das Ausgeben einer Farbrezeptur für die erste Beschichtung, die Farbrezeptur den Satz einer oder mehreren Farbkomponenten enthält, und/oder wobei die erste Farbkurve eine Reflexionskurve oder ein Spektrum ist, das für die erste Beschichtung repräsentativ ist,
wobei bevorzugt das Identifizieren des Satzes der Komponenten auf dem Berechnen der Reflexionskurven basiert.

9. Das System (200) nach einem der Ansprüche 1 bis 8, wobei das Erzeugen eines Satzes einer oder mehrerer Farbkomponenten aus einer Ausgabe des physiktrainierten Algorithmus für maschinelles Lernen ferner enthält: Auswählen einer Untergruppe zufälliger Komponenten und schrittweises Anpassen jeder Untergruppe zufälliger Komponenten bis die zweite Farbkurve einen Genauigkeitsschwellenwert relativ zur ersten Farbkurve erfüllt und/oder wobei das Modell (110) ein hierarchisches Modell für maschinelles Lernen (110) ist, in dem die Kubelka-Munk-Farbtheorie als erste Annäherung an die Reflexionskurve verwendet wird und dann geschätzte Reflexionswerte aus einem historischen Satz beschichteter Bleche als Eingabe für das Modell für maschinelles Lernen (110) verwendet werden.

10. Ein computerimplementiertes Verfahren, das auf einem oder mehreren Prozessoren (205) ausgeführt wird, wobei das computerimplementierte Verfahren zur Farbanpassung umfasst:
Empfangen (405) einer Farbmessung (120) einer ersten Beschichtung von einem Spektralphotometer (115), wobei die Farbmessung (120) eine erste Farbkurve umfasst,
Verarbeiten (410) von Informationen, die aus der ersten Farbkurve abgeleitet wurden, mit einem physiktrainierten Algorithmus für maschinelles Lernen, wobei eine Strahlungstransferfunktion als Regulierungsmittel fungiert, das einen Raum zulässiger Lösungen innerhalb des physiktrainierten Algorithmus für maschinelles Lernen begrenzt, und
Erzeugen (415) eines Satzes einer oder mehrerer Farbkomponenten, die, wenn sie gemischt werden, der ersten Beschichtung entsprechen, aus einer Ausgabe des physiktrainierten Algorithmus für maschinelles Lernen.

11. Das computerimplementierte Verfahren gemäß Anspruch 10 ferner umfassend:
Bestimmen einer zweite Farbkurve für die erste Beschichtung basierend zumindest teilweise auf der ersten Farbkurve,
Verarbeiten der erste Farbkurve und der zweite Farbkurve mit dem physiktrainierten Algorithmus für maschinelles Lernen und
Erzeugen einer dritten Farbkurve auf der Grundlage der ersten Farbkurve und der zweiten Farbkurve aus dem physiktrainierten Algorithmus für maschinelles Lernen, wobei bevorzugt die Erzeugung des Satzes einer oder mehrerer Farbkomponenten, die, wenn sie gemischt werden, der ersten Beschichtung entsprechen, aus dem physiktrainierten Algorithmus für maschinelles Lernen enthält:
Identifizieren des Satzes einer oder mehrerer Farbkomponenten, die, wenn sie gemischt werden, der dritten Farbkurve entsprechen, und
Ausgeben einer Farbrezeptur für die erste Beschichtung, wobei die Farbrezeptur den Satz einer oder mehrerer Farbkomponenten enthält.

12. Das computerimplementierte Verfahren gemäß einem der Ansprüche 10 bis 11, wobei das Erzeugen des Satzes einer oder mehrerer Farbkomponenten ferner umfasst:
Berechnen (515) einer mit jedem Toner assoziierten Reflexionskurve, wobei das Identifizieren des Satzes einer oder mehrerer Farbkomponenten zumindest teilweise auf dem Berechnen (515) der mit jedem Toner assoziierten Reflexionskurve basiert und/oder wobei das Berechnen der Reflexionskurve umfasst:
Anwenden eines Regressionsmodells mit Gaußschen Prozessenauf Daten, die jedem Toner zugeordnet sind, wobei das Berechnen der Reflexionskurve zumindest teilweise auf dem Anwenden des Regressionsmodells mit Gaußschen Prozessen basiert.

13. Das computerimplementierte Verfahren gemäß einem der Ansprüche 10 bis 12, wobei das Erzeugen des Satzes einer oder mehrerer Farbkomponenten umfasst:
Umwandeln von Daten, die mit der Farbmessung (120) verbunden sind, in dreidimensionale Koordinaten in einem Farbraum und
Auswählen einer oder mehrerer Komponenten mit Koordinaten, die die erste Beschichtung im Farbraum umgeben, die zumindest teilweise auf der Umwandlung der Farbmessung (120) der ersten Beschichtung basieren, wobei der Farbraum bevorzugt einen CIELab-Farbraum umfasst.

14. Das computerimplementierte Verfahren gemäß einem der Ansprüche 10 bis 13, wobei das Erzeugen des Satzes einer oder mehrerer Farbkomponenten umfasst:
parallele Bestimmung (615) mehrerer Farbkurven, die zumindest teilweise auf der Analyse mehrerer Komponenten, Tonerkonzentrationen,
Kombinationen von Komponenten oder einer beliebigen Kombination davon basieren, und/oder
wobei die Analyse mehrerer Komponenten, Tonerkonzentrationen,
Kombinationen von Komponenten oder einer beliebigen Kombination davon zumindest teilweise auf historischen Beschichtungssprühergebnissen basiert.

15. Ein nicht-transitorisches, computerlesbares Medium, das ein oder mehrere computerlesbare Speichermedien umfasst, auf denen computerausführbare Befehle (215) gespeichert sind, die, wenn sie auf einem Prozessor (205) ausgeführt werden, ein Computersystem veranlassen, ein Verfahren zur Farbanpassung durchzuführen, wobei das Verfahren umfasst:
Empfangen (405) einer Farbmessung (120) einer ersten Beschichtung von einem Spektralphotometer (115), wobei die Farbmessung (120) einer ersten Farbkurve entspricht,
Verarbeiten (410) von Informationen, die aus der ersten Farbkurve abgeleitet wurden, mit einem physiktrainierten Algorithmus für maschinelles Lernen, wobei eine Strahlungstransferfunktion als Regulierungsmittel fungiert, das einen Raum zulässiger Lösungen innerhalb des physiktrainierten Algorithmus für maschinelles Lernen begrenzt, und Erzeugen (415) eines Satzes einer oder mehrerer Farbkomponenten, die, wenn sie gemischt werden, der ersten Beschichtung entsprechen, aus einer Ausgabe des physiktrainierten Algorithmus für maschinelles Lernen.

## Revendications

1. Système (200) de correspondance de couleurs, comprenant :
un ou plusieurs processeurs (205) ; et
un ou plusieurs supports lisibles par ordinateur sur lesquels sont stockées des instructions exécutables (215) qui, lorsqu'elles sont exécutées par les un ou plusieurs processeurs (205), configurent le système pour :
recevoir (400), à partir d'un spectrophotomètre (115), une mesure de couleur (120) d'un premier revêtement, dans lequel la mesure de couleur (120) comprend une première courbe de couleur ;
traiter (410), avec un algorithme d'apprentissage automatique guidé par la physique, des informations dérivées de la première courbe de couleur, dans lequel une fonction de transfert radiatif joue le rôle d'agent de régularisation qui limite un espace de solutions admissibles au sein de l'algorithme d'apprentissage automatique guidé par la physique ; et
générer (415), à partir d'une sortie de l'algorithme d'apprentissage automatique guidé par la physique, un ensemble d'une ou de plusieurs composantes de couleur qui, si elles sont mélangées, correspondent au premier revêtement.

2. Système (200) selon la revendication 1, dans lequel les un ou plusieurs supports lisibles par ordinateur comprennent en outre des instructions exécutables (215) qui, lorsqu'elles sont exécutées par un processeur (205), configurent le système pour :
déterminer une deuxième courbe de couleur pour le premier revêtement sur la base, au moins en partie, de la première courbe de couleur ;
traiter, avec l'algorithme d'apprentissage automatique guidé par la physique, la première courbe de couleur et la deuxième courbe de couleur ; et
générer, à partir de l'algorithme d'apprentissage automatique guidé par la physique, une troisième courbe de couleur sur la base de la première courbe de couleur et de la deuxième courbe de couleur, de préférence dans lequel les instructions exécutables (215) pour générer, à partir de l'algorithme d'apprentissage automatique guidé par la physique, l'ensemble d'une ou de plusieurs composantes de couleur qui, si elles sont mélangées, correspondent au premier revêtement comprennent des instructions qui, lorsqu'elles sont exécutées par un processeur (205), configurent le système pour :
identifier l'ensemble d'une ou de plusieurs composantes de couleur qui, si elles sont mélangées, correspondent à la troisième courbe de couleur ; et
délivrer une recette de couleur pour le premier revêtement, la recette de couleur comprenant l'ensemble d'une ou de plusieurs composantes de couleur.

3. Système (200) selon l'une quelconque des revendications 1 ou 2, dans lequel les instructions exécutables (215) pour traiter, à l'aide d'un algorithme d'apprentissage automatique guidé par la physique, des informations dérivées de la première courbe de couleur comprennent des instructions qui, lorsqu'elles sont exécutées par un processeur (205), configurent le système pour :
traiter, à l'aide d'un algorithme d'apprentissage automatique guidé par la physique, la première courbe de couleur et la deuxième courbe de couleur, dans lequel la fonction de transfert radiatif joue le rôle d'agent de régularisation qui limite l'espace de solutions admissibles au sein de l'algorithme d'apprentissage automatique guidé par la physique, et/ou dans lequel les instructions exécutables (215) pour générer l'ensemble d'un ou de plusieurs composantes de couleur comprennent des instructions qui, lorsqu'elles sont exécutées par un processeur (205), configurent le système pour :
calculer une courbe de réflectance associée à chaque toner, dans lequel la courbe de réflectance est utilisée pour identifier l'ensemble d'une ou de plusieurs composantes de couleur,
de préférence dans lequel les instructions exécutables (215) pour calculer la courbe de réflectance comprennent des instructions qui, lorsqu'elles sont exécutées par un processeur (205), configurent le système pour :
appliquer un modèle de régression de processus gaussien aux données associées à chaque toner, dans lequel le calcul de la courbe de réflectance est basé, au moins en partie, sur l'application du modèle de régression de processus gaussien.

4. Système (200) selon l'une quelconque des revendications 1 à 3, dans lequel les instructions exécutables (215) pour générer l'ensemble d'une ou de plusieurs composantes de couleur comprennent des instructions qui, lorsqu'elles sont exécutées par un processeur (205), configurent le système pour :
convertir les données associées à la mesure de couleur (120) en coordonnées tridimensionnelles dans un espace colorimétrique ; et
sélectionner une ou plusieurs composantes ayant des coordonnées qui entourent le premier revêtement dans l'espace colorimétrique sur la base, au moins en partie, de la conversion de la mesure de couleur (120) du premier revêtement,
de préférence dans lequel l'espace colorimétrique comprend un espace colorimétrique CIELab.

5. Système (200) selon l'une quelconque des revendications 1 à 3, dans lequel les instructions exécutables (215) pour générer l'ensemble d'une ou de plusieurs composantes de couleur comprennent des instructions qui, lorsqu'elles sont exécutées par un processeur (205), configurent le système pour :
déterminer (615) de multiples courbes de couleur en parallèle sur la base, au moins en partie, d'une analyse de multiples composantes, concentrations de toner, combinaisons de composantes, ou de toute combinaison de celles-ci.
de préférence dans lequel l'analyse de multiples composantes, concentrations de toner, combinaisons de composantes, ou de toute combinaison de celles-ci est basée, au moins en partie, sur des historiques de pulvérisations de revêtements.

6. Système (200) selon l'une quelconque des revendications 1 à 5, dans lequel l'algorithme d'apprentissage automatique guidé par la physique comprend un algorithme d'apprentissage automatique utilisant la théorie de Kubelka-Munk comme agent de régularisation.

7. Système (200) selon l'une quelconque des revendications 1 à 6, dans lequel une fonction Kubelka-Munk est utilisée comme fonction de transfert radiatif pour déterminer la première courbe de couleur et/ou la deuxième courbe de couleur.

8. Système (200) selon l'une quelconque des revendications 1 à 7, dans lequel le traitement des informations dérivées de la première courbe de couleur, à l'aide d'un algorithme d'apprentissage automatique guidé par la physique, comprend :
la détermination d'une deuxième courbe de couleur pour le premier revêtement sur la base, au moins en partie, de la première courbe de couleur, et
la génération, à partir de l'algorithme d'apprentissage automatique guidé par la physique, d'une troisième courbe de couleur sur la base de la première courbe de couleur et de la deuxième courbe de couleur, et
dans lequel la génération, à partir d'une sortie de l'algorithme d'apprentissage automatique guidé par la physique, d'un ensemble d'une ou de plusieurs composantes de couleur qui, si elles sont mélangées, correspondent à la troisième courbe de couleur au lieu de la première courbe de couleur, et qui comprennent en outre la sortie d'une recette de couleur pour le premier revêtement, la recette de couleur comprenant l'ensemble d'une ou de plusieurs composantes de couleur, et/ou
dans lequel la première courbe de couleur est une courbe ou un spectre de réflectance représentatif du premier revêtement,
de préférence dans lequel l'identification de l'ensemble de composantes est basée sur le calcul des courbes de réflectance.

9. Système (200) selon l'une quelconque des revendications 1 à 8, dans lequel la génération, à partir d'une sortie de l'algorithme d'apprentissage automatique guidé par la physique, d'un ensemble d'une ou de plusieurs composantes de couleur comprend en outre :
la sélection d'un sous-ensemble de composantes aléatoires et l'ajustement de chaque sous-ensemble de composantes aléatoires de manière incrémentielle jusqu'à ce que la deuxième courbe de couleur satisfasse à un seuil de précision par rapport à la première courbe de couleur, et/ou dans lequel le modèle d'apprentissage automatique (110) est un modèle d'apprentissage automatique hiérarchique (110) dans lequel la théorie des couleurs de Kubelka-Munk est utilisée comme première approximation de la courbe de réflectance et ensuite des valeurs de réflectance estimées à partir d'un ensemble historique de panneaux revêtus sont utilisées comme entrée pour le modèle d'apprentissage automatique (110).

10. Procédé implémenté par ordinateur, exécuté par un ou plusieurs processeurs (205), le procédé implémenté par ordinateur étant pour la correspondance de couleurs, comprenant :
la réception (405), à partir d'un spectrophotomètre (115), d'une mesure de couleur (120) d'un premier revêtement, dans lequel la mesure de couleur (120) comprend une première courbe de couleur ;
le traitement (410), avec un algorithme d'apprentissage automatique guidé par la physique, d'informations dérivées de la première courbe de couleur, dans lequel une fonction de transfert radiatif joue le rôle d'agent de régularisation qui limite un espace de solutions admissibles au sein de l'algorithme d'apprentissage automatique guidé par la physique ; et
la génération (415), à partir d'une sortie de l'algorithme d'apprentissage automatique guidé par la physique, d'un ensemble d'une ou de plusieurs composantes de couleur qui, si elles sont mélangées, correspondent au premier revêtement.

11. Procédé implémenté par ordinateur selon la revendication 10, comprenant en outre :
la détermination d'une deuxième courbe de couleur pour le premier revêtement sur la base, au moins en partie, de la première courbe de couleur ;
le traitement, avec l'algorithme d'apprentissage automatique guidé par la physique, de la première courbe de couleur et de la deuxième courbe de couleur ; et
la génération, à partir de l'algorithme d'apprentissage automatique guidé par la physique, d'une troisième courbe de couleur sur la base de la première courbe de couleur et de la deuxième courbe de couleur, de préférence dans lequel la génération, à partir de l'algorithme d'apprentissage automatique guidé par la physique, de l'ensemble d'une ou de plusieurs composantes de couleur qui, si elles sont mélangées, correspondent au premier revêtement comprend :
l'identification de l'ensemble d'une ou de plusieurs composantes de couleur qui, si elles sont mélangées, correspondent à la troisième courbe de couleur ; et
la sortie d'une recette de couleur pour le premier revêtement, la recette de couleur comprenant l'ensemble d'une ou de plusieurs composantes de couleur.

12. Procédé implémenté par ordinateur selon l'une quelconque des revendications 10 à 11, dans lequel la génération de l'ensemble d'une ou de plusieurs composantes de couleur comprend en outre :
le calcul (515) d'une courbe de réflectance associée à chaque toner, dans lequel l'identification de l'ensemble d'une ou de plusieurs composantes de couleur est basée, au moins en partie, sur le calcul (515) de la courbe de réflectance associée à chaque toner, et/ou dans lequel le calcul de la courbe de réflectance comprend :
l'application d'un modèle de régression de processus gaussien aux données associées à chaque toner, dans lequel le calcul de la courbe de réflectance est basé, au moins en partie, sur l'application du modèle de régression de processus gaussien.

13. Procédé implémenté par ordinateur selon l'une quelconque des revendications 10 à 12, dans lequel la génération de l'ensemble d'une ou de plusieurs composantes de couleur comprend :
la conversion des données associées à la mesure de couleur (120) en coordonnées tridimensionnelles dans un espace colorimétrique ; et
la sélection d'une ou de plusieurs composantes ayant des coordonnées qui entourent le premier revêtement dans l'espace colorimétrique sur la base, au moins en partie, de la conversion de la mesure de couleur (120) du premier revêtement,
de préférence dans lequel l'espace colorimétrique comprend un espace colorimétrique CIELab.

14. Procédé implémenté par ordinateur selon l'une quelconque des revendications 10 à 13, dans lequel la génération de l'ensemble d'une ou de plusieurs composantes de couleur comprend :
la détermination (615) de multiples courbes de couleur en parallèle sur la base, au moins en partie, d'une analyse de multiples composantes, concentrations de toner, combinaisons de composantes, ou de toute combinaison de celles-ci, et/ou dans lequel l'analyse de multiples composantes, concentrations de toner, combinaisons de composantes, ou de toute combinaison de celles-ci est basée, au moins en partie, sur des historiques de pulvérisations de revêtements.

15. Support non transitoire lisible par ordinateur comprenant un ou plusieurs supports de stockage lisibles par ordinateur sur lesquels sont stockées des instructions exécutables par ordinateur (215) qui, lorsqu'elles sont exécutées par un processeur (205), amènent un système informatique à effectuer un procédé de correspondance de couleurs, le procédé comprenant :
la réception (405), à partir d'un spectrophotomètre (115), d'une mesure de couleur (120) d'un premier revêtement, dans lequel la mesure de couleur (120) correspond à une première courbe de couleur ;
le traitement (410), avec un algorithme d'apprentissage automatique guidé par la physique, d'informations dérivées de la première courbe de couleur, dans lequel une fonction de transfert radiatif joue le rôle d'agent de régularisation qui limite un espace de solutions admissibles au sein de l'algorithme d'apprentissage automatique guidé par la physique ; et
la génération (415), à partir d'une sortie de l'algorithme d'apprentissage automatique guidé par la physique, d'un ensemble d'une ou de plusieurs composantes de couleur qui, si elles sont mélangées, correspondent au premier revêtement.
